# EUROPEAN PATENT APPLICATION

(11) **EP 0 653 836 A1**
(43) Date of publication of application: **17.05.1995**
(21) Application number: 94117404.7
(22) Date of filing: 04.11.1994
(51) Int. Cl.: H03F 3/50, H03F 3/185

(54) **Final stage of audio-frequency amplification operating in class A**

(30) Priority: 12.11.1993 IT PD930226
(71) Applicant: Borinato, Gianni, I-36100 Vicenza (IT)
(72) Inventor: Borinato, Gianni, I-36100 Vicenza (IT)
(74) Representative: La Ciura, Salvatore

(57) **Abstract**

The invention relates to a final stage of audio-frequency amplification operating in class A in which the amplifier is a follower fed by constant current, where an inductance is provided between the MOSFET source and the bonding, and the follower is obtained with a MOSFET device.

## Description

The object of the present invention is a final stage of audio-frequency amplification operating in class A.

Audio-frequency power amplifiers with a final stage operating in class A are known being used in the high fidelity field.

These amplifiers, though having low efficiency, are highly appreciated, since they produce a signal distortion which is much lower than the signal distortion produced by the amplifiers with a final stage operating in class B or AB.

A circuit solution which is adopted in the final amplification stages operating in class A uses, as an active device, a thermionic valve, usually in the common cathode configuration.

Such a solution has drawbacks due to its weight, its overall size and the need to dissipate large quantities of heat.

Another circuit solution uses, as an active device, a bipolar junction transistor, usually in the common emitter configuration.

The main drawback of this solution is less perfect sound reproduction, due to the narrower range in which the operation of the active device may be considered linear.

Another circuit solution which, with regard to the acoustic result, tries to combine the advantages of the thermionic valve and of the bipolar junction transistor, as for weight, size and heat dissipation, consists in using, as an active device, a MOS Field Effect Transistor, usually in the common source configuration.

As known, amplifiers with this kind of circuit configuration have high output impedance, whereas loudspeakers, as known, have low impedance.

Moreover, these amplifiers have low input impedance, whereas intermediate amplification stages, usually having a common emitter configuration, have high output impedance.

Therefore, impedance matching between the output of the amplifier and the input of the loudspeaker is necessary to guarantee the maximum power transfer.

Similarly, also impedance matching between the intermediate and the final amplification stages is often necessary.

Suitable low frequency transformers are used for this purpose. However, the use of transformers increases, besides the weight and the overall size of the apparatus, also production costs.

Moreover, the use of transformers causes non linear distortions due to the saturation of the ferromagnetic core of the transformer.

These amplifiers, then, have a rather narrow passband and, consequently, untrue reproduction of the frequencies next to the lower and/or higher limit of the audio band.

The main object of the present invention is to eliminate the above-mentioned drawbacks, by providing an amplifier operating in class A with low output impedance, thus eliminating the need to use matching transformers.

Another object of the present invention is to produce an amplifier which is reliable as well as easy and cheap to manufacture.

A further object of the present invention is to produce an amplifier having a wider passband.

Last, but not least, object of the present invention is to produce an amplifier with a high conversion rate and a low merit figure.

These and other aims are achieved by using a final stage of audio-frequency amplification operating in class A according to the characterizing portion of the enclosed claims.

Further characteristics and advantages will become clearer from the description of a preferred, but not exclusive embodiment of the amplifier, shown by way of non restrictive example in the enclosed drawings, in which:
- Figure 1 shows the basic circuit diagram of the amplifier according to the invention;
- Figure 2 shows another preferred embodiment of the amplifier according to the invention.

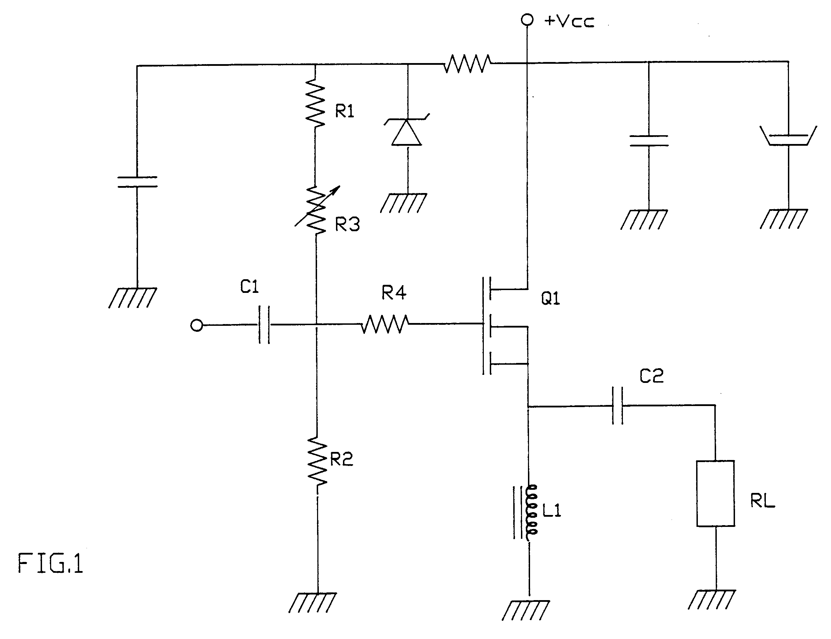

With reference to Figure 1, the amplifier of the present invention uses a MOS Field Effect Transistor Q1 in the source follower configuration, said source being bonded by interposing inductance L1.

Said source follower includes resistors R1, R2, R3, R4, for the MOSFET gate polarization.

The amplifier is matched with the input signal by means of capacity C1 and with the load RL by means of capacity C2.

The source follower, as known, has high input impedance and low output impedance.

The fact of having low output impedance advantageously avoids the need to match impedance and, therefore, makes it possible to match the load with the amplifier by means of a capacitor.

Similarly, the fact of having high input impedance makes it possible to match the output of the intermediate amplification stage, which usually has high output impedance, with the input of the final stage by means of a capacitor, thus avoiding the need to match impedance.

This kind of amplifier offers a high current gain, and a voltage gain which is positive, but lower than a unit.

As known, the bigger the source resistance is, the better the source follower operates.

However, high source resistance implies a high feeding voltage, with the risk, in dynamic operation, of applying, between source and drain, voltages which are higher than breakdown voltages, thus endangering the device itself.

Therefore, it is useful to interpose, between the MOSFET source and the bonding, inductance L1, which has low static resistance and high dynamic resistance.

The use of inductance L1 makes it possible to maintain the static loadline of Q1 parallel to the Y-axis of the Cartesian plane on which the operation of the device is shown, by changing, on the contrary, the inclination of the dynamic loadline, namely by rotating it counterclockwise.

Thus, output voltage can be higher than feeding voltage, even reaching a peak-to-peak value which is theoretically twice the value of feeding voltage.

This implies a high conversion rate, which theoretically gets up to 50%, and a low merit figure, which theoretically has the value 2.

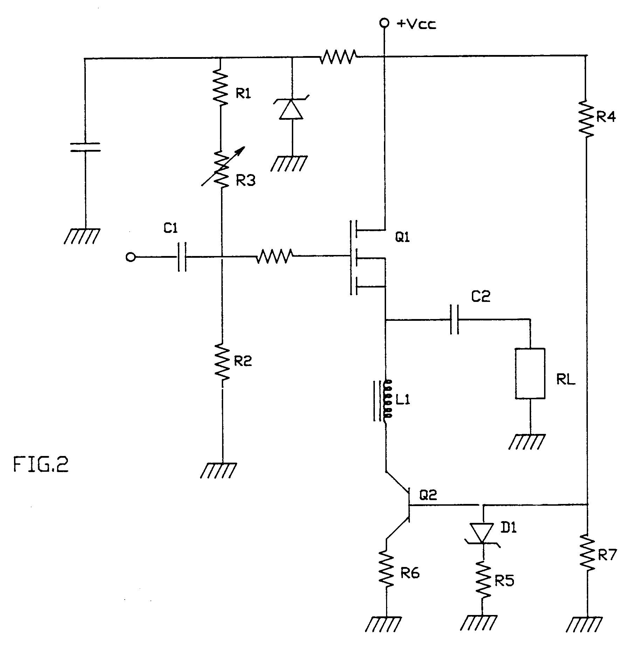

Conveniently, it is possible to interpose, between inductance L1 and the bonding, a constant current generator (Fig. 2), which increases the difference between the static and dynamic resistance as seen from the source, thus further improving the performance of the amplifier.

A preferred, but not exclusive, embodiment of said constant current generator includes a NPN bipolar junction transistor Q2, a polarization circuit of said transistor comprising resistors R4, R5, R6 and R7 and a diode D1 counteracting the thermal drifts of transistor Q2.

Anyway, the present invention may be subject to several modifications and variations, all of them falling within the scope of the invention.

## Claims

1. A final stage of audio-frequency amplification operating in class A, consisting of a single active component, characterized in that it is provided with an inductance which is placed between the source or emitter and the bonding.

2. A final stage of audio-frequency amplification, according to claim 1, characterized in that the amplifier is matched with the load by means of a capacitor.

3. A final stage of amplification, according to any of the preceding claims, characterized in that the input of the final stage of amplification is matched with the output of the previous stage of amplification by means of a capacitor.

4. A final stage of audio-frequency amplification operating in class A, consisting of a single active device, characterized in that it includes:
- a MOSFET in the source follower configuration;
- a capacitor matching the source and the load;
- a capacitor between the output of the previous stage of amplification and the gate;
- an inductance between the source and the bonding.

5. A final stage of amplification, according to claim 1 or 4, characterized in that said follower is fed by means of a constant current generator, said constant current generator being connected with the source by means of said inductance.

6. A final stage according to claims 1 and 5, characterized in that said constant current generator includes:
- a bipolar junction transistor with a common emitter;
- a polarization circuit.

7. A final stage, according to claim 6, characterized in that in the polarization circuit of the constant current generator a diode counteracts the thermal drifts of the bipolar junction transistor.
